# EUROPÄISCHE PATENTSCHRIFT

(11) **EP 0 404 977 B1**
(45) Veröffentlichungstag und Bekanntmachung des Hinweises auf die Patenterteilung: **28.09.1994**
(21) Anmeldenummer: 89111767.3
(22) Anmeldetag: 28.06.1989
(51) Int. Cl.: H01L 27/02

(54) **Eingangsschutzstruktur für integrierte Schaltungen**
Input protection structure for integrated circuits
Structure de protection d'entrée pour circuits intégrés

(43) Veröffentlichungstag der Anmeldung: 02.01.1991
(73) Patentinhaber: SIEMENS AKTIENGESELLSCHAFT, 80333 München (DE)
(72) Erfinder: Becker, Burkhard, Dr.rer.nat., D-8000 München 80 (DE)

(56) Entgegenhaltungen:
- GB-A- 2 176 053
- PATENT ABSTRACTS OF JAPAN, Band 5, Nr. 145 (E-74)[817], 12. September 1981 & JP-A-56 79 463
- PATENT ABSTRACTS OF JAPAN, Band 12, Nr. 239 (E-630)[3086], 7. Juli 1988 & JP-A-63 31 153

## Beschreibung

Die vorliegende Erfindung betrifft eine Eingangsschutzstruktur gegen elektrostatische Entladungen für integrierte Schaltungen, welche
- zwischen einen Eingang und ein Referenzpotential geschaltet ist,
- mindestens einen bipolaren Transistor mit einem integrierten Widerstand aufweist,
- dessen Kollektor mit dem Eingang verbunden ist und dessen Basis über den Widerstand und gemeinsam mit seinem Emitter an das Referenzpotential angeschlossen ist.

Integrierte Schaltungen benötigen einen sicheren Schutz gegen elektrostatische Entladungen. Sich auf derartige elektrostatische Entladungen beziehende Mechanismen sind im einzelnen in der Veröffentlichung Patent Abstracts of Japan 12(239), (E-630) <3086> erläutert. Aus dieser Druckschrift ist insbesondere eine Eingangsschutzstruktur für bipolare integrierte Schaltungen bekannt, die aus einem zwischen einen Eingang und ein Referenzpotential geschalteten npn-Transistor besteht, dessen Basis über einen Widerstand gekoppelt (kurzgeschlossen) ist und auf Referenzpotential - speziell Masse - liegt.

Der Transistor ist derart realisiert, daß eine erste als Kollektor wirkende Dotierungszone in einen Halbleitersubstrat eingebracht ist, innerhalb der eine weitere als Basis wirkende Dotierungszone angeordnet ist. Innerhalb der Basisdotierungszone wiederum ist eine als Emitter wirkende Dotierungszone gebildet. Alle Dotierungszonen reichen bis zur Oberfläche des Halbleitersubstrats und werden dort kontaktiert.

Bei dieser üblichen Ausgestaltung des Transistors können aufgrund der erhöhten Ladungsträgerdichte in der Nähe der Systemoberfläche Oberflächenfrühdurchbrüche auftreten, wodurch die Reproduzierbarkeit der Einsatzspannung der Schutzstruktur nicht sicher gewährleistet werden kann.

Der vorliegenden Erfindung liegt daher die Aufgabe zugrunde, eine Eingangsschutzstruktur der in Rede stehenden Art anzugeben, die eine hohe Festigkeit gegen Oberflächendurchbrüche aufweist.

Diese Aufgabe wird bei einer Eingangsschutzstruktur der eingangs genannten Art dadurch gelöst, daß
- der Kollektor in einem Halbleitersubstrat eines ersten Leitfähigkeitstyps als vergrabener Kollektor eines zweiten Leitfähigkeitstyps ausgebildet ist,
- eine weitere vergrabene Diffusionszone des ersten Leitfähigkeitstyps auf dem vergrabenen Kollektor gebildet ist, die in einem ersten Teilbereich als Basis und in einem zweiten Teilbereich als integrierter Widerstand wirkt,
- der Emitter als Teil einer auf dem Halbleitersubstrat aufgebrachten epitaktischen Schicht des zweiten Leitfähigkeitstyps ausgebildet ist,
- der als Emitter wirkende Teil der epitaktischen Schicht über dem ersten Teilbereich der weiteren vergrabenen Diffusionszone angeordnet ist und von einer von der Oberfläche der epitaktischen Schicht bis zur weiteren vergrabenen Diffusionszone reichenden obere Diffusionszone des ersten Leitfähigkeitstyps umgeben ist.

Weiterbildungen der Erfindung sind Gegenstand von Unteransprüchen.

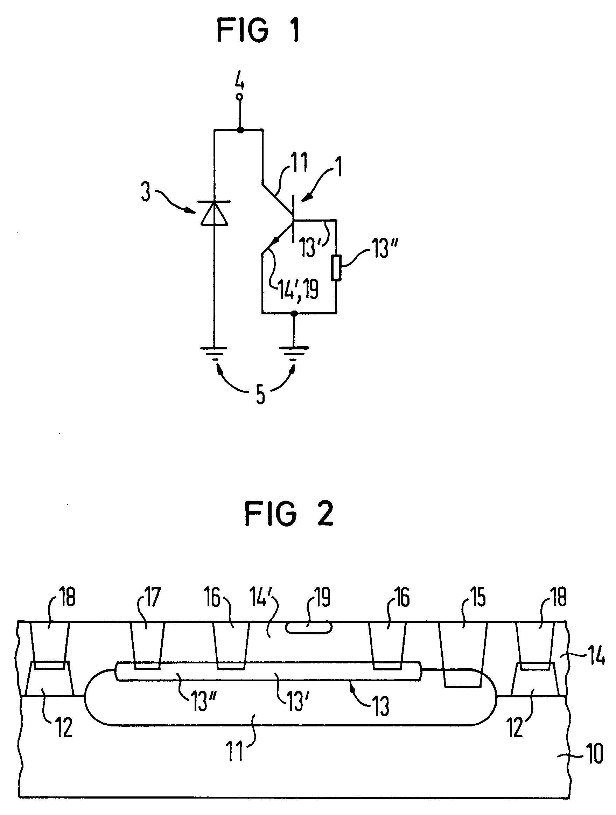

Die Erfindung wird im folgenden anhand eines Ausführungsbeispiels gemäß den FIG 1 und 2 der Zeichnung näher erläutert. Es zeigt:
- FIG 1: ein Ersatzschaltbild einer Eingangsschutzstruktur in Form einer Diode und eines Transistors der oben bereits diskutierten Art, womit ein Schutz gegen elektrostatische Entladungen beider Polaritäten möglich ist; und
- FIG 2: eine schematische Darstellung der Realisierung einer Eingangsschutzstruktur nach FIG 1 in einem Halbleitersystem.

Gemäß FIG 1 liegt zwischen einem Eingangsanschluß 4 einer integrierten Schaltung, insbesondere einer bipolaren integrierten Schaltung, und einem Referenzpotential, insbesondere Masse, eine Schutzstruktur, welche durch einen Transistor 1 mit der oben bereits erläuterten Kopplung zwischen Basis 13′ und Emitter 14′,19 über einen Widerstand 13˝ sowie einen Kollektor 11 und eine Diode 3 gebildet ist. Insbesondere ist dabei der Kollektor 11 des Transistors 1 an den Eingangsanschluß 4 und der Verbindungspunkt zwischen Emitter 14′,19 und Widerstand 13˝ an das Bezugspotential 5 angeschlossen. Aufgrund der sich aus FIG 1 ergebenden Schaltungspolaritäten des Transistors 1 und der Diode 3 wirkt diese Schutzstruktur für elektrostatische Entladungen beider Polaritäten.

Die Bezugszeichen nach FIG 1, insbesondere für den Transistor 1 und dessen Beschaltung durch den Widerstand 13˝ sind in Übereinstimmung mit den Bezugszeichen nach FIG 2 des im folgenden zu erläuternden Halbleitersystems gewählt, in dem die Schutzstruktur realisiert ist. Die Schutzstruktur im Halbleitersystem nach FIG 2 wird im folgenden anhand der schematischen Verfahrensabfolge bei der Herstellung erläutert.

Ausgangspunkt für die Herstellung des Halbleitersystems nach FIG 2 ist ein Halbleitersubstrat 10 eines Leitungstyps, bei dem es sich vorzugsweise um den p-Leitungstyp handelt. In dieses Halbleitersystem wird in an sich konventioneller Weise zunächst eine insbesondere hochdotierte Zone des entgegengesetzten Leitungstyps, im vorliegenden Beispiel also des n-Leitungstyps, eindiffundiert, durch die mit den nachfolgenden Herstellungsschritten eine buried layer-Zone 11 gebildet wird. Weiterhin werden in das Halbleitersubstrat Zonen mit dem Leitungstyp des Halbleitersubstrats eindiffundiert, welche ebenfalls in Verbindung mit den nachfolgenden Herstellungsschritten Teilzonen 12 eines an sich üblichen Isolationsrahmens bilden.

Vorzugsweise gleichzeitig mit der Eindiffusion der die Teilzonen 12 des Isolationsrahmens bildenden Zonen wird in das Halbleitersubstrat 10 oberhalb der buried layer-Zone 11 eine Zone 13 mit dem Leitungstyp des Halbleitersubstrats 10, im vorliegenden Fall also mit p-Leitungstyp, eindiffundiert, wodurch sich in Verbindung mit den nachfolgenden Herstellungsschritten die in FIG 2 dargestellte Konfiguration der beiden Zonen 11 und 13 ergibt.

Nach der Eindiffusion der Zonen 11,12 und 13 wird in an sich üblicher Weise auf das insoweit behandelte Halbleitersubstrat 10 eine epitaktische Schicht 14 mit gegenüber dem Halbleitersubstrat 10 entgegengesetzten Leitungstyps, im vorliegenden Beispiel also mit n-Leitungstyp, aufgebracht. Wie im folgenden noch genauer erläutert wird, wird für die den Kollektor eines Transistors entsprechend dem Transistor 1 nach FIG 1 bildende Zone 11 eine hochdotierte Anschlußzone 15 mit dem Leitungstyp der buried layer-Zone 11 durch die epitaktische Schicht hindurch bis in die buried layer-Zone 11 hineinreichend eindiffundiert.

Nachfolgend werden in einem weiteren Diffusionsschritt Zonen 16,17 und 18 mit dem Leitungstyp des Halbleitersubstrats 10, im vorliegenden Ausführungsbeispiel also mit p-Leitungstyp in die epitaktische Schicht 14 eingebracht, wobei die Zone 16 als geschlossener Ring bis in die Zone 13 hineinreicht und einen Bereich 14⁻ der epitaktischen Schicht 14 vollständig umschließt. Die Zone 17 dient als Anschlußzone für die Zone 13. Schließlich vervollständigen die in die Teilzonen 12 hineinreichenden Zonen 18 den an sich konventionellen Isolationsring für den gesamten die Zonenfolge 11 bis 17 enthaltenden Bereich des Halbleitersystems.

Schließlich wird in das Gebiet 14′ der epitaktischen Schicht 14 eine insbesondere hochdotierte Zone 19 vom Leitungstyp der epitaktischen Schicht 14, im vorliegenden Ausführungsbeispiel also vom n-Leitungstyp, eindiffundiert.

Aufgrund der vorstehend erläuterten Zonenstruktur ergibt sich im Halbleitersystem ein Transistor entsprechend dem Transistor 1 nach FIG 1, dessen Kollektor durch die buried layer-Zone 11 mit dem Kollektoranschluß 15, dessen Basis durch einen Teilbereich 13′ der Zone 13, und dessen Emitter durch das Gebiet 14′ mit der Emitterdiffusion 19 gebildet wird. Der die Basis 13′ und den Emitter 14′,19 koppelnde Widerstand 13˝ gemäß FIG 1 wird im System nach FIG 2 durch einen Teilbereich 13˝ der Zone 13 gebildet. Die Zone 17 bildet dabei eine Anschlußzone, welche über eine in FIG 2 nicht dargestellte Leiterbahn mit der Emitterdiffusionszone 19 verbunden ist und damit die an Bezugspotential 5 anschließbare Verbindung zwischen dem Emitter 14′,19 des Transistors 1 und dem von der Basis abgewandten Anschluß des Widerstandes 13˝ gemäß FIG 1 bildet.

In einer weiteren Ausführungsform kann die Zone 13 auch so dimensioniert werden, daß sie über die buried layer-Zone 11 hinausragt und das Substrat 10 an der von der Basis abgewandten Seite des Widerstandes 13˝ kontaktiert. Dann entfällt der Basisanschluß 17, dessen Funktion von einem Substratanschluß, z.B. dem Isolationsrahmen 12,18, übernommen wird.

Im Halbleitersystem nach FIG 2 bilden also die Zonen 12 und 13 untere Diffusionsgebiete, während die Zonen 16,17 und 18 obere Diffusionsgebiete bilden. Gemäß einem besonderen Merkmal der Erfindung überdeckt die die Basis 13′ und den Widerstand 13˝ bildende Zone die den Kollektor bildende buried layer-Zone 11 im wesentlichen, d.h., abgesehen von der Kollektoranschlußzone 15 überdeckt die Zone 13 die buried layer-Zone größtenteils. Damit wird es möglich, den Wert des Widerstandes 13˝ und damit die Einsatzspannung der Schutzstruktur in gewünschter Weise einzustellen.

In Weiterbildung der Erfindung wird über die Kollektoranschlußzone 15 und den pn-Übergang zwischen der buried layer-Zone 11 und dem Halbleitersubstrat 10 eine Diode gebildet, welche der Diode 3 nach FIG 1 entspricht.

Wie bereits erläutert, wird beim Halbleitersystem nach FIG 2 der Eingang durch die Kollektoranschlußzone 15 gebildet. Den Ausgang bildet die Emitterdiffusionszone 19 innerhalb des durch die ringförmige Zone 16 eingeschlossenen Bereiches 14′ der epitaktischen Schicht 14 sowie die untere Diffusionszone 13 mit der Basis 13′ und dem Widerstand 13˝ über die Anschlußzone 17. Wie bereits ausgeführt, sind die Zonen 17 und 19 direkt miteinander verbunden (kurzgeschlossen; nicht dargestellt). Ersichtlich bilden die Emitterdiffusionszone 19, das Gebiet 14′ der epitaktischen Schicht 14, der Bereich 13′ der Zone 13 sowie die buried layer-Zone 11 einen vertikalen npn-Transistor mit der bereits angegebenen Zonenfolge Emitter, Basis, Kollektor. Eine solche Struktur erweist sich insbesondere für Prozeßlinien mit großer Dicke der epitaktischen Schicht 14 im Hinblick auf die Schutzwirkung gegen elektrostatische Entladungen als besonders günstig. Ein konventioneller npn-Transistor der eingangs erläuterten Art etwa nach der DE-OS 36 16 394 mit flachen Diffusionszonen bzw. Diffusionsgebieten wäre dabei weniger vorteilhaft, da bei positiven Eingangsimpulsen eine zu große Sperrschichtweite innerhalb der epitaktischen Schicht zwischen Basis- und Kollektoranschluß und damit eine zunehmende Gefahr der Zerstörung des Bauelementes durch Lawinendurchbrüche zu erwarten ist. Bei der erfindungsgemäßen Struktur fließt der Strom vom Kollektoranschluß 15 innerhalb des Kristalls über die Zone 13 in vertikaler Richtung zum Emitter- bzw. Basisanschluß. Ein Oberflächendurchbruch ist damit ausgeschlossen.

Negative Spannungsimpulse werden einerseits über die durch die buried layer-Zone 11 und das Halbleitersubstrat 10 gebildete Diode, aber auch über den Emitteranschluß nach Bezugspotential (Masse) abgeführt, da der Transistor der Schutzstruktur im inversen Betrieb arbeitet, wobei der Basis-Emitter-Übergang in Sperrichtung gepolt ist.

Durch die durch die untere Diffusionszone 13 gebildete Basis 13′ sowie die Anordnung der Kollektor-,Emitter- und Basisanschlüsse wird eine Homogenisierung des Feldstärke- und Stromverlaufs erreicht. Aufgrund der Ausgestaltung der Basis sowie des im isolierten Bereich 14′ ausgebildeten Emitters können keine Teilbereiche des Emitter-Basis-Übergangs mit kleinem Krümmungsradius entstehen, wie dies bei konventionellen flachen Emitter- und Basisdiffusionen der Fall ist. Bei der erfindungsgemäßen Struktur können daher keine Überlastungen aufgrund zu hoher örtlicher Stromdichten entstehen.

Positive Spannungsimpulse schalten die Kollektor-Basis-Diode des Transistors 1 in Sperrichtung sowie die Basis-Emitter-Diode in Durchlaßrichtung. Über den kurzgeschlossenen Basisanschluß 17 kann ein Stromfluß aus der Basis 13′ erfolgen, so daß die Schutzstruktur in die normale Transistorarbeitsweise übergeht. Durch die Erdung des Basisanschlusses 17 erfolgt das Durchschalten des Transistors in Form eines Durchbruchs über die Kollektor-Emitter-Strecke in Verbindung mit der Widerstandskopplung zwischen Basis und Emitter.

Die vorstehend erläuterte Schutzstruktur leitet Spannungsimpulse aufgrund ihrer kurzen Durchschaltzeit ab, bevor parallelliegende Funktionseinheiten in der zu schützenden integrierten Schaltung zerstört werden können. Die Polung des empfindlichen Basis-Emitter-Übergangs in Durchlaßrichtung garantiert zudem eine hohe Belastbarkeit der Schutzstruktur.

Der Vorteil der erfindungsgemäßen Schutzstruktur liegt insbesondere in ihrer Verwendungsmöglichkeit für hohe Signalspannungen der zu schützenden integrierten Schaltung.

## Patentansprüche

1. Eingangsschutzstruktur gegen elektrostatische Entladungen für integrierte Schaltungen, welche
- zwischen einen Eingang (4) und ein Referenzpotential (5) geschaltet ist,
- mindestens einen bipolaren Transistor (1) mit einem integrierten Widerstand (13˝) aufweist,
- dessen Kollektor (11) mit dem Eingang (4) verbunden ist und dessen Basis (13) über den Widerstand (13˝) und gemeinsam mit seinem Emitter (14′,19) an das Referenzpotential (5) angeschlossen ist,
**dadurch gekennzeichnet,** daß
- der Transistor (1) ein vertikaler bipolarer Transistor ist,
- der Kollektor (11) in einem Halbleitersubstrat (10) eines ersten Leitfähigkeitstyps als vergrabener Kollektor eines zweiten Leitfähigkeitstyps ausgebildet ist, eine weitere vergrabene Diffusionszone (13) des ersten Leitfähigkeitstyps auf dem vergrabenen Kollektor (11) gebildet ist, die in einem ersten Teilbereich (13′) als Basis und in einem zweiten Teilbereich (13˝) als integrierter Widerstand wirkt,
- der Emitter (14′,19) als Teil einer auf dem Halbleitersubstrat (10) aufgebrachten epitaktischen Schicht (14) des zweiten Leitfähigkeitstyps ausgebildet ist,
- der als Emitter wirkende Teil (14′) der epitaktischen Schicht (14) über dem ersten Teilbereich (13′) der weiteren vergrabenen Diffusionszone (13) angeordnet ist und von einer von der Oberfläche der epitaktischen Schicht (14) bis zur weiteren vergrabenen Diffusionszone (13) reichenden oberen Diffusionszone (16) des ersten Leitfähigkeitstyps umgeben ist.

2. Eingangsschutzstruktur nach Anspruch 1, **dadurch gekennzeichnet,** daß die weitere vergrabene Diffusionszone (13) den vergrabenen Kollektor (11) im wesentlichen überdeckt.

3. Eingangsschutzstruktur nach einem der Ansprüche 1 oder 2, **dadurch gekennzeichnet,** daß der zwischen der oberen Diffusionszone (16) und einer als Basisanschluß wirkenden weiteren oberen Diffusionszone (17) liegende Teil (13˝) der weiteren vergrabenen Diffusionszone (13) den integrierten Widerstand bildet.

4. Eingangsschutzstruktur nach einem der Ansprüche 1 bis 3, **dadurch gekennzeichnet,** daß der vergrabene Kollektor (11) und das Halbleitersubstrat (10) eine integrierte Schutzdiode (3) bilden.

## Claims

1. Input structure of protection against electrostatic discharges for integrated circuits, which
- is connected between an input (4) and a reference potential (5),
- exhibits at least one bipolar transistor (1) with an integrated resistor (13˝),
- the collector (11) of which is connected to the input (4) and the base (13) of which is connected via the resistor (13˝) and jointly with its emitter (14′,19) to the reference potential (5),
characterized in that
- the transistor (1) is a vertical bipolar transistor,
- the collector (11) is constructed as buried collector of a second type of conductivity in a semiconductor substrate (10) of a first type of conductivity,
- a further buried diffusion zone (13) of the first type of conductivity is formed on the buried collector (11), which zone acts as base in a first part-area (13′) and as integrated resistor in a second part-area (13˝),
- the emitter (14′,19) is constructed as part of an epitaxial layer (14) of the second type of conductivity applied to the semiconductor substrate (10),
- the part (14′) of the epitaxial layer (14), which acts as emitter, is arranged above the first part-area (13′) of the further buried diffusion zone (13) and is surrounded by an upper diffusion zone (16) of the first type of conductivity extending from the surface of the epitaxial layer (14) to the further buried diffusion zone (13).

2. Input protection structure according to Claim 1, characterized in that the further buried diffusion zone (13) essentially covers the buried collector (11).

3. Input protection structure according to one of Claims 1 or 2, characterized in that the part (13˝) of the further buried diffusion zone (13), which is located between the upper diffusion zone (16) and a further upper diffusion zone (17) acting as base terminal, forms the integrated resistor.

4. Input protection structure according to one of Claims 1 to 3, characterized in that the buried collector (11) and the semiconductor substrate (10) form an integrated protection diode (3).

## Revendications

1. Structure de protection d'entrée vis-à-vis de décharges électrostatiques pour des circuits intégrés, qui
- est branchée entre une entrée (4) et un potentiel de référence (5), possède au moins un transistor bipolaire (1) possédant une résistance intégrée (13˝),
- dont le collecteur (11) est relié à l'entrée (4) et dont la base (13) est connectée par l'intermédiaire de la résistance (13˝) et conjointement avec son émetteur (14′, 19) au potentiel de référence (5),
caractérisée par le fait que
- le transistor (1) est un transistor bipolaire vertical,
- le collecteur (11) est formé, en tant que collecteur enseveli possédant un second type de conductivité, dans un substrat semiconducteur (10) possédant un premier type de conductivité,
- une autre zone de diffusion ensevelie (13) possédant le premier type de conductivité est formée dans le collecteur enseveli (11), cette zone de diffusion agissant en tant que base dans une première région partielle (13′) et en tant que résistance intégrée dans une seconde région partielle (13˝),
- l'émetteur (14′,19) est agencé en tant que partie d'une couche épitaxiale (14) déposée sur le substrat semiconducteur (10) et possédant le second type de conductivité,
- la partie (14′), qui agit en tant qu'émetteur, de la couche épitaxiale (14) est disposée au-dessus de la première région partielle (13′) de l'autre zone de diffusion ensevelie (13) et est entourée par une zone supérieure de diffusion (16) possédant le premier type de conductivité, qui s'étend de la surface de la couche épitaxiale (14) jusqu'à l'autre zone de diffusion ensevelie (13).

2. Structure de protection d'entrée suivant la revendication 1, caractérisée par le fait que l'autre zone de diffusion ensevelie (13) recouvre pour l'essentiel le collecteur enseveli (11).

3. Structure de protection d'entrée suivant l'une des revendications 1 ou 2, caractérisée par le fait que la partie (13˝), qui est située entre la zone supérieure de diffusion (16) et une autre zone supérieure de diffusion (17) agissant en tant que borne de base, de l'autre zone de diffusion ensevelie (13) forme la résistance intégrée.

4. Structure de protection d'entrée suivant l'une des revendications 1 à 3, caractérisée par le fait que le collecteur enseveli (11) et le substrat semiconducteur (10) forment une diode de protection intégrée (3).
